# EUROPÄISCHE PATENTSCHRIFT

(11) **EP 1 935 220 B1**
(45) Veröffentlichungstag und Bekanntmachung des Hinweises auf die Patenterteilung: **21.07.2010**
(21) Anmeldenummer: 06804345.4
(22) Anmeldetag: 11.10.2006
(51) Int. Cl.: H05K 7/14

(54) **VORRICHTUNG ZUR MONTAGE EINER PRINTPLATTE UND ZUR WÄRMEABLEITUNG**
DEVICE FOR MOUNTING A PRINTED CIRCUIT BOARD AND FOR HEAT DISSIPATION
DISPOSITIF DE MONTAGE D'UNE CARTE A CIRCUITS IMPRIMES ET DE DISSIPATION DE CHALEUR

(30) Priorität: 11.10.2005 AT 16532005
(43) Veröffentlichungstag der Anmeldung: 25.06.2008
(73) Patentinhaber: Fronius International GmbH, 4643 Pettenbach (AT)
(72) Erfinder: EHRENGRUBER, Andreas, A-4655 Vorchdorf (AT); IGELSBÖCK, Manfred, A-4623 Gunskirchen (AT); PRIELINGER, Andreas, A-4655 Vorchdorf (AT)
(74) Vertreter: Sonn & Partner Patentanwälte
(86) Internationale Anmeldenummer: PCT/AT2006/000417
(87) Internationale Veröffentlichungsnummer: WO 2007/041738

(56) Entgegenhaltungen:
- DE-A1- 3 705 331
- DE-A1- 10 123 198
- DE-A1- 19 924 344
- DE-U1- 20 112 594

## Beschreibung

Die Erfindung betrifft eine Montagevorrichtung für eine Printplatte, wie im Oberbegriff des Anspruchs 1 beschrieben ist.

Aus dem Stand der Technik sind Vorrichtungen zur Montage von Printplatten in einem Gehäuse bekannt, wobei die Printplatten beispielsweise am Gehäuse mit bevorzugt mehreren Schrauben befestigt wird oder durch eine Steckverbindung am Gehäuse fixiert wird.

Ebenso ist aus dem Stand der Technik bekannt, dass zur Ableitung der von elektronischen Bauteilen produzierten Wärme hauptsächlich die entsprechenden Bauteile auf einer Printplatte, welche eine erhöhte Wärmeentwicklung aufweisen, mit einem Kühlkörper verbunden werden. Dadurch wird die produzierte Wärme der Bauteile über den Kühlkörper an die Umgebungsluft abgegeben und die Bauteile gekühlt. Ist hierbei die Printplatte in einem Gehäuse eingebaut bzw. montiert, muss beispielsweise die vom Kühlkörper abgegebene Wärme durch einen Lüfter vom Gehäuse entfernt werden, sodass der Kühlkörper weiterhin seine Funktion erfüllt.

Die DE 37 05 331 A1 beschreibt eine Montagevorrichtung für eine Printplatte, die einen einfachen Ein- und Ausbau der Printplatte ermöglicht. Auf die Abführung der üblicherweise von elektronischen Bauteilen produzierten Wärme wird in diesem Dokument nicht eingegangen.

Die DE 201 12 594 U1 zeigt ein elektronisches Steuergerät in Fahrzeugen, wobei außenseitig am Gehäuse Kühlrippen angeformt sind, sodass die Wärme der Printplatte abgeführt werden kann.

Die DE 199 24 344 A1 zeigt ein Gehäuse für eine Printplatte, welches durch eine einfache Bauweise gekennzeichnet ist. Die möglichst effiziente Abfuhr der Wärme aus dem Inneren des Gehäuses wird nicht behandelt.

Schließlich zeigt die DE 101 23 198 A1 ein Gehäuse für eine Printplatte bei dem zur Abführung der Wärme von den elektronischen Bauelementen die Printplatte zur Aufnahme eines Teils eines Kühlkörpers ausgenommen ist.

Nachteilig ist hierbei, dass die durch den Kühlkörper abgegebene Wärme im inneren des Gehäuses bleibt, wodurch sich dieses dementsprechend erwärmt. Daher müssen bei erhöhter Wärmeentwicklung durch die Bauteile auf der Printplatte im Gehäuse zusätzliche Lüftungsschlitze integriert sein oder ein Lüfter eingesetzt werden, damit die Bauteile ausreichend gekühlt werden bzw. die erforderliche Abfuhr der Wärme aus dem Gehäuse gewährleistet wird. Des weiteren kann daher das Gehäuse nicht witterungsfest bzw. wasserdicht aufgebaut werden, da hierbei keine Wärmeabfuhr mehr gewährleistet bzw. mit einem dementsprechend hohen Aufwand verbunden ist.

Die Aufgabe der Erfindung liegt darin, eine Vorrichtung zur Montage einer Printplatte in einem Gehäuse, insbesondere für ein Batterieladegerät, zu schaffen, womit ein geschlossener Aufbau des Gehäuses und gleichzeitig eine Abfuhr der produzierten Wärme nach außen ermöglicht wird.

Die Aufgabe der Erfindung wird dadurch gelöst, dass das Druckelement als Kühlelement ausgebildet ist und zur Wärmeübertragung von der Printplatte zum Gehäuse dient, wobei das Befestigungselement in die Führungsschiene einführbar ist und gleichzeitig zur Aufnahme der Printplatte ausgebildet ist.

Vorteilhaft ist hierbei, dass dadurch ein geschlossener Aufbau des Gehäuses erreicht wird, welches somit unabhängig von den Witterungsbedingungen ist. Zusätzlich wird hierbei die im geschlossenen Gehäuse produzierte Wärme über das Gehäuse, welches den Kühlkörper bildet, nach außen geleitet, wodurch keine zusätzliche Kühlung, wie beispielsweise durch einen Lüfter, erforderlich ist. Des weiteren wird in vorteilhafter Weise durch den Einsatz eines wärmeleitfähigen Elementes erreicht, dass die Printplatte vor Vibrationen des Gehäuses geschützt ist. Ebenso kann dadurch die Größe des Gehäuses minimiert werden bzw. besser an die Anforderungen angepasst werden, da die Verwendung einer zusätzlichen Kühlung entfällt. Selbstverständlich wird dadurch auch der Aufwand für die Montage des Gehäuses reduziert, da keinerlei Schraubverbindungen für das Befestigen der Printplatte notwendig ist, sodass eine schnelle und kostengünstige Montage bzw. Demontage möglich ist.

In vorteilhafter Weise wird durch den planflächigen Kontakt zwischen Kühlelement und Kühlkörper erreicht, dass die Wärmeabfuhr vom Inneren des Gehäuses nach außen wesentlich verbessert wird.

Durch die Maßnahme, dass die Seitenwände des Gehäuses lösbar und witterungsfest mit dem Gehäuse verbunden sind, wird in vorteilhafter Weise erreicht, dass die Aufnahme der Printplatte von beiden Seiten erfolgen kann. Ebenso wird das Verfahren zur Herstellung des Gehäuses, also dem Kühlkörper, wesentlich erleichtert, woraus sich niedrigere Herstellungskosten ergeben.

Von Vorteil ist auch, dass durch die Maßnahmen, dass die Montage der Printplatte im Kühlkörper ohne Hilfsmittel durch eine ruckartige Bewegung der Printplatte erfolgt, die Zeit für die Montage wesentlich verringert wird.

In vorteilhafter Weise wird durch die schräge Fläche der Vorsprünge erreicht, dass die Printplatte für die Aufnahme im Gehäuse gehalten wird. Ebenso ist dadurch ein minimaler Abstand zwischen Kühlelement und Kühlkörper hergestellt, wodurch die Aufnahme erleichtert wird. Des weiteren wird die Fixierung der Printplatte erleichtert, wobei ein Kontakt zwischen Kühlelement und Kühlkörper hergestellt wird.

Von Vorteil ist auch, dass durch die Befestigungselemente gleichzeitig die Befestigung der Printplatte und der Kontakt zwischen Kühlelement und Kühlkörper ermöglicht wird. Dadurch kann die Fertigung der Printplatte komplett eigenständig durchgeführt werden, woraus sich eine beschleunigte Montage ohne Hilfsmittel ergibt.

Durch die Maßnahme, dass die Befestigungselemente einen definierten Abstand zwischen Kühlkörper und Printplatte bewirken, wird in vorteilhafter Weise erreicht, dass der Abstand auf einfache Art und Weise der Größe des Kühlelementes angepasst werden kann, welche von der produzierten Wärme der Bauteile auf der Printplatte abhängig ist.

Die vorliegende Erfindung wird anhand der beigefügten, schematischen Zeichnungen näher erläutert.

Darin zeigen:
Fig. 1 eine exemplarische Darstellung eines Gehäuses, welches die Befestigung einer Printplatte ermöglicht;
Fig. 2 eine schematische Darstellung des Querschnitts des erfindungsgemäßen Gehäuses;
Fig. 3 eine schematische Darstellung der Anordnung für die Wärmeableitung;
Fig. 4 eine schematische Darstellung eines Details der Anordnung für die Wärmeableitung;
Fig. 5 eine schematische Darstellung eines Befestigungselementes für die Printplatte im Schrägriss;
Fig. 6 eine schematische Darstellung eines Befestigungselementes für die Printplatte im Aufriss;
Fig. 7 einen Teilbereich des Befestigungselementes, dem Vorsprung;
Fig. 8 einen Teilbereich des Befestigungselementes, dem Vorsprung, und der Leiterplatte beim Einschieben;
Fig. 9 einen Teilbereich des Befestigungselementes, dem Vorsprung, und die fixierte Leiterplatte;
Fig. 10 das Einschieben der Printplatte in das Gehäuse in schematischer Darstellung; und
Fig. 11 die im Gehäuse fixierte Printplatte in schematischer Darstellung.

Einführend wird festgehalten, dass gleiche Teile des Ausführungsbeispiels mit gleichen Bezugszeichen versehen werden.

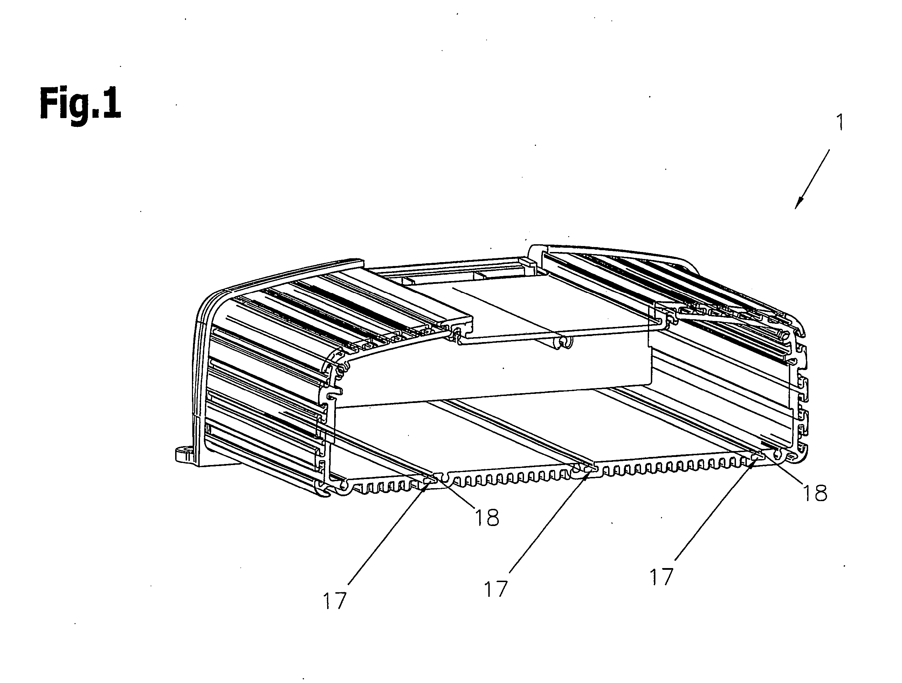

In Fig. 1 ist ein Gehäuse 1 dargestellt, welches zur Aufnahme einer Printplatte 2 ausgebildet ist.

Das Gehäuse 1 weist zur Aufnahme der Printplatte 2 beispielsweise sogenannte Führungsschienen 17 auf. Diese Führungsschienen 17 dienen zur Befestigung und Positionierung der Printplatte 2 im Gehäuse 1. Aus diesem Grund weisen die Führungsschienen 17 eine Nut 18 auf. Hierbei ermöglicht die Nut 18 eine Verbindung zwischen der Führungsschiene 17 und der Printplatte 2.
Des weiteren ist die Form und Größe des Gehäuses 1 grundsätzlich der Größe der Printplatte 2 angepasst, sodass diese problemlos im Gehäuse 1 entsprechend positioniert und befestigt werden kann.

Die Printplatte 2 ist mit elektronischen Bauteilen 3 bestückt, welche dementsprechend untereinander verbunden sind, sodass eine elektronische Schaltung gebildet wird. Je nach Einsatz der Schaltung, beispielsweise für Batterieladegeräte, werden unterschiedliche Bauteile 3 benötigt. Insbesondere für Batterieladegeräte ist ein Leistungsteil 4 erforderlich. Da der Leistungsteil 4 hohe Ströme verarbeitet bzw. schaltet, bewirkt der Leistungsteil 4 eine dementsprechende Wärmeentwicklung. Diese produzierte Wärme muss dementsprechend abgeleitet werden, damit die Schaltung nicht negativ beeinflusst wird bzw. die entsprechenden Bauteile 3 nicht überhitzt werden.

Wie aus dem Stand der Technik bekannt, erfolgt die Ableitung der Wärme über sogenannte Kühlkörper 5. Hierbei wird der Kühlkörper 5 entsprechend mit dem Bauteil 3, von welchem die Wärme abgeleitet werden muss, verbunden. Somit nimmt der Kühlkörper 5 die Wärme auf und führt diese wiederum an die Umgebungsluft ab. Dabei wird die Abfuhr der von den am Kühlkörper 5 befestigten Bauteilen 3 produzierten Wärme durch die entsprechend höhere Wärmeleitfähigkeit des Materials des Kühlkörper 5 an die Umgebungsluft begünstigt.

Befindet sich eine derartige Schaltung in einem geschlossenen Gehäuse 1, wird dementsprechend die produzierte Wärme über den Kühlkörper 5 an die Luft im Gehäuse 1 abgegeben. Da in einem geschlossenen Gehäuse 1 keine Luftzirkulation stattfindet, erwärmt sich die Luft dementsprechend und somit kann der Kühlkörper 5 seine Funktion nicht erfüllen.

Eine entsprechende Luftzirkulation kann beispielsweise durch den Einsatz eines zusätzlichen Lüfters erreicht werden. Dieser ersetzt dann die warme Luft im Gehäuse 1, welche vom Kühlkörper 5 abgegeben wird, mit der Umgebungsluft außerhalb des Gehäuses 1. Somit ist das Gehäuse 1 nicht mehr geschlossen, woraus resultiert, dass in ein geschlossenes Gehäuse 1 keine Printplatte 2, welche einen wärmeproduzierenden Leistungsteil 4 und somit entsprechend zumindest einen Kühlkörper 5 aufweist, integriert werden kann.

Erfindungsgemäß wird das Gehäuse 1 nun derart ausgebildet, dass die durch den Leistungsteil 4 der Schaltung produzierte Wärme über das geschlossene Gehäuse 1 an die Umgebungsluft abgegeben wird. Das heißt, dass das Gehäuse 1 die Funktion des Kühlkörpers 5 übernimmt. Somit kann ein geschlossenes Gehäuse 1, welches Unabhängig der Witterung ist, realisiert werden.

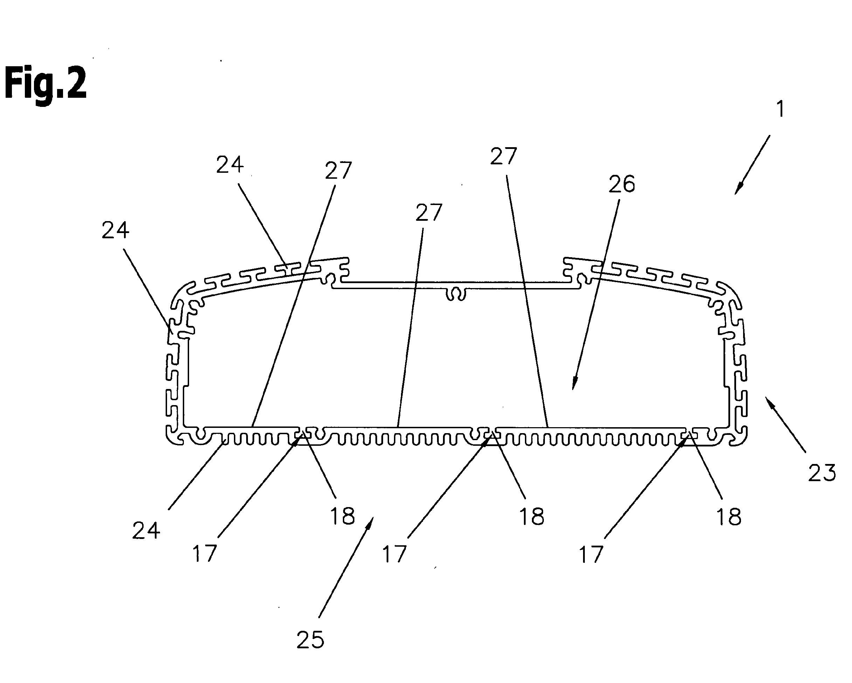

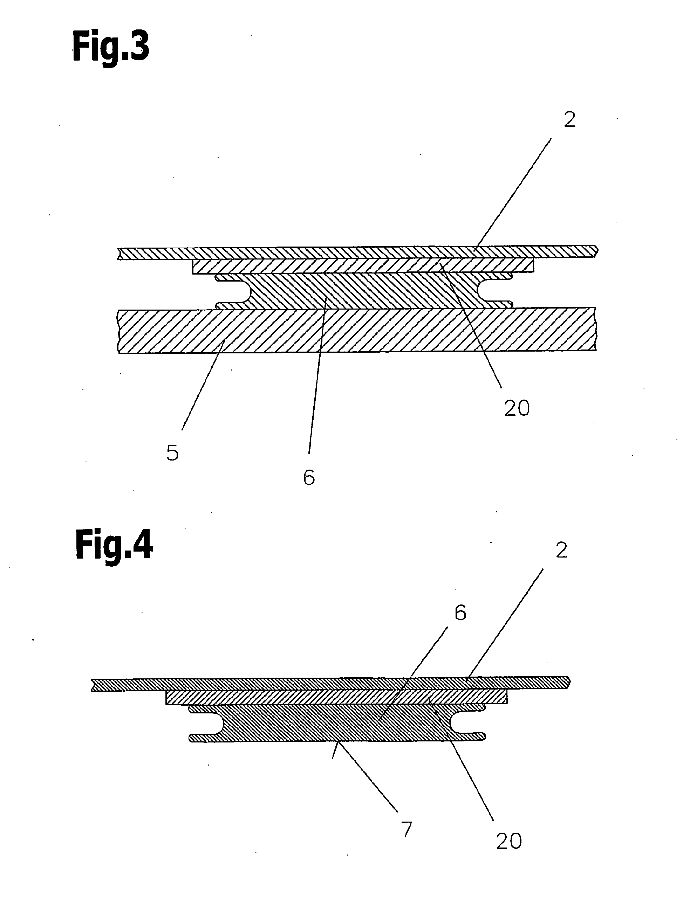

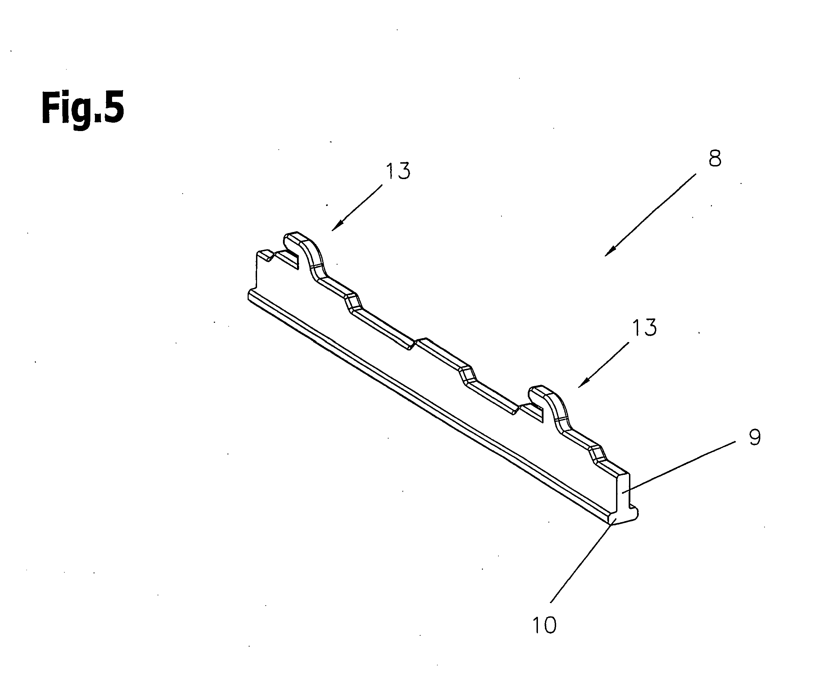

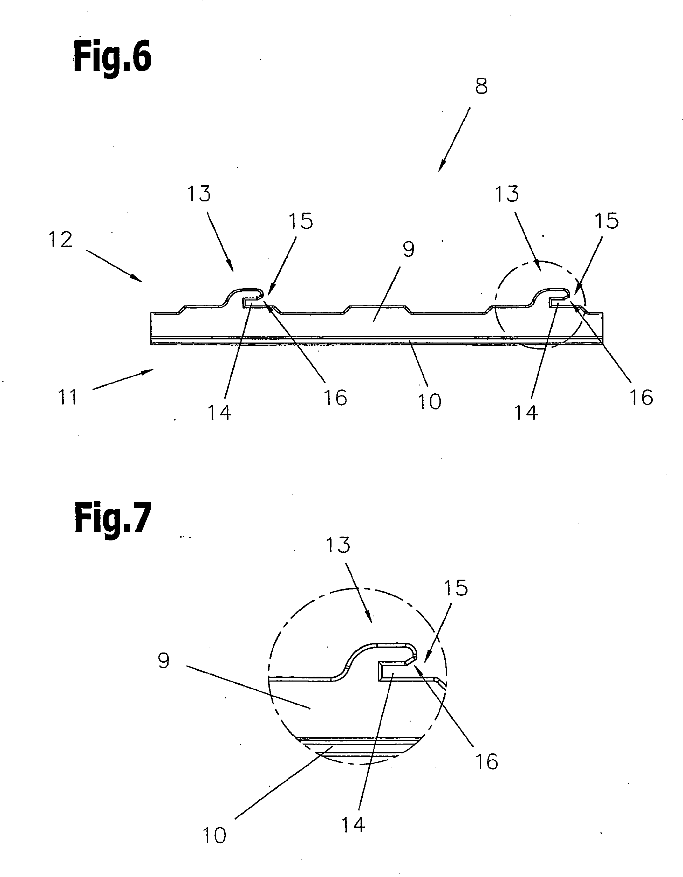

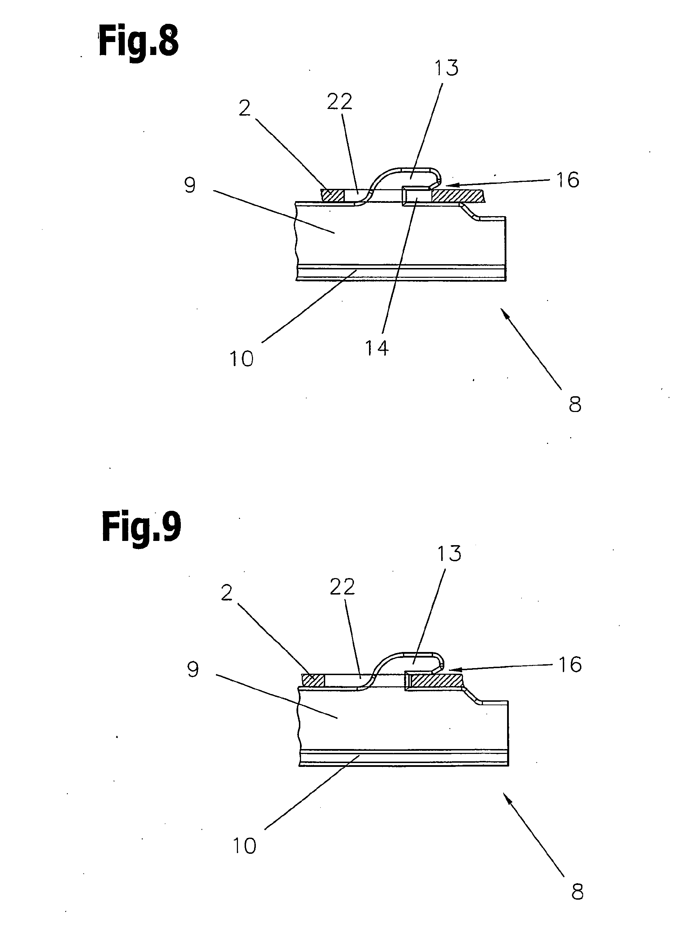

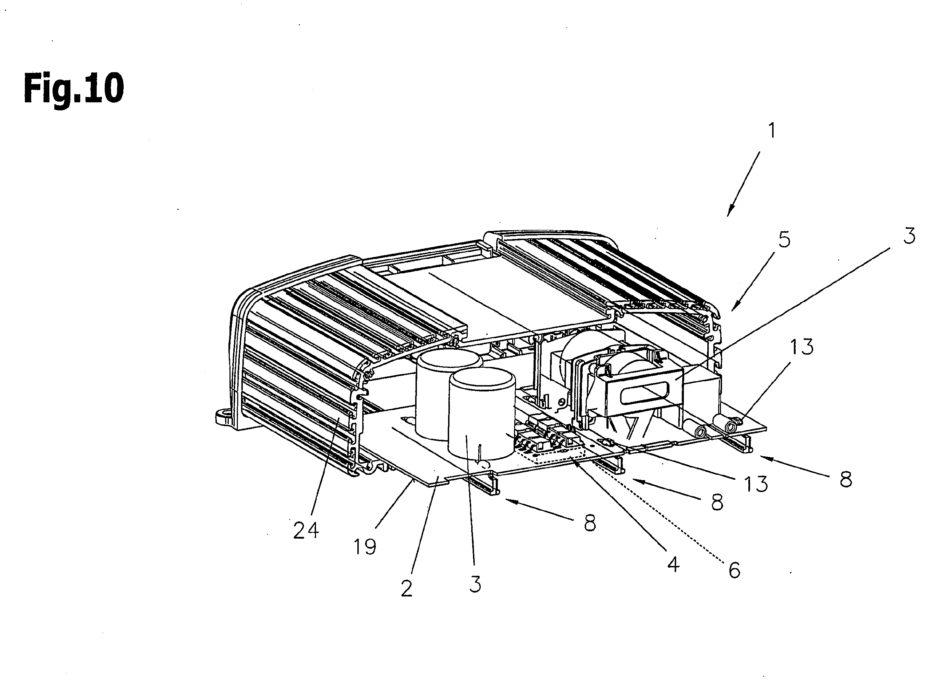

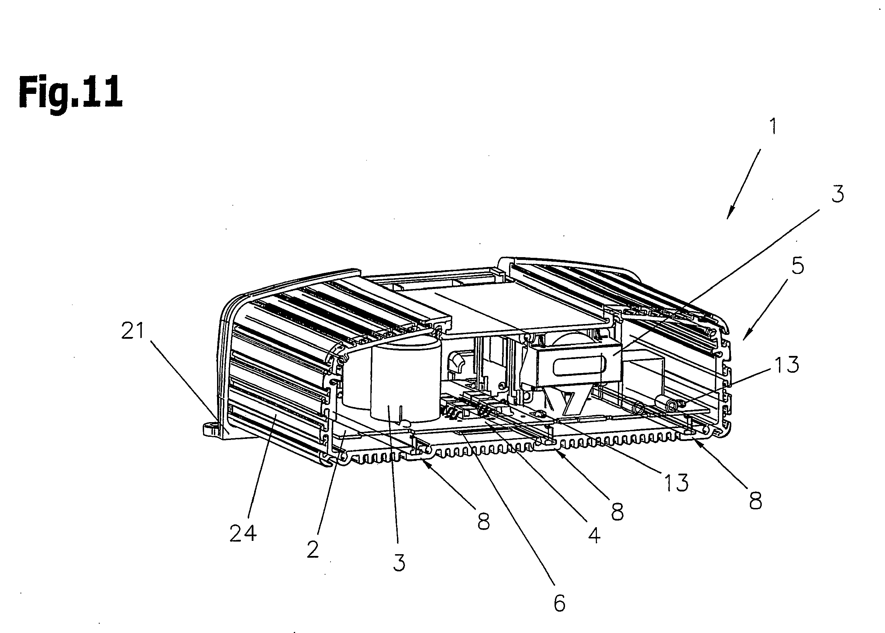

Da erfindungsgemäß das Gehäuse 1 die Funktion des Kühlkörpers 5 übernimmt, ist dieses dementsprechend ausgebildet. Dies ist in den Fig. 2 bis 11 dargestellt bzw. beschrieben.

So weist das Gehäuse 1 auf seiner Außenseite 23 bevorzugt Kühlrippen 24 auf, welche die Fläche der Außenseite 23 des Gehäuses 1 vergrößern und die Wärme an die Umgebungsluft abgeben. Ebenso ist es möglich, insbesondere wenn die zu abführende Wärme gering ist, dass die Außenseite 23 glatt ausgeführt ist, also keine Kühlrippen 24 aufweist. Die Wärmeabfuhr wird begünstigt durch die halbkreisförmige Ausbildung des Gehäuses 1. Selbstverständlich ist es jedoch auch möglich, dass eine beliebige Form für das Gehäuse 1 gewählt wird.

Die horizontale Unterseite 25 des Gehäuses 1 weist hierbei in der Innenseite 26 des Gehäuses 1 die Führungsschienen 17 auf. Des weiteren sind die Teilbereiche 27 der Unterseite 25 auf der Innenseite 26 zwischen den Führungsschienen 17 bevorzugt planflächig, wodurch die vom Leistungsteil 4 der Printplatte 2 produzierte Wärme auf das Gehäuse 1 übergeleitet bzw. abgegeben werden kann. Somit erfüllt das Gehäuse 1 die Funktion des Kühlkörpers 5.

Bevorzugt erfolgt die Überleitung der Wärme von der Printplatte 2 auf den Kühlkörper 5 über ein Kühlelement 6, welches ebenso die Funktion eines Kühlkörpers 5 erfüllt. Hierzu ist das Kühlelement 6 mit den Bauteilen 3 des Leistungsteils 4 verbunden, wobei das Kühlelement 6 beispielsweise auf der Unterseite 19 der Printplatte 2 montiert ist. Somit wird die produzierte Wärme des leistungsteil 4 vom Kühlelement 6 aufgenommen. Damit nun das Kühlelement 6 die Wärme an den Kühlkörper 5 überleiten kann, weist das Kühlelement 6 eine planflächige Seite 7 auf. Diese planflächige Seite 7 stellt den Kontakt zum Kühlkörper 5 her, wenn die Printplatte 2 am Gehäuse 1 bzw. dem Kühlkörper 5 befestigt ist. Hierbei ist die Printplatte 2 bevorzugt lösbar am Kühlkörper 5 befestigt.

Die Befestigung der Printplatte 2 am Kühlkörper 5 erfolgt über die Führungsschienen 17, welche ein Befestigungselement 8 aufnehmen. Dieses erfindungsgemäße Befestigungselement 8 weist grundsätzlich die Form einer Schiene bzw. eine T-Form auf, also einen senkrechten Balken 9 und einen normal dazu angeordneten Querbalken 10. Für die Befestigung der Printplatte 2 am Kühlkörper 5 bildet der Querbalken 10 die Unterseite 11 des Befestigungselementes 8. Die Länge des Befestigungselementes 8 entspricht im wesentlichen der Breite der Printplatte 2, wobei diese im wesentlichen der Breite bzw. der Tiefe des Kühlkörpers 5 bzw. dem Gehäuse 1 entspricht.

Die Oberseite 12 des Befestigungselementes 8 dient zur Auflage der Printplatte 2, wobei die Auflagefläche, also die Oberseite 12, dementsprechend der Unterseite 19, sprich der Lötseite 7, angepasst ist. Des weiteren weist die Oberfläche 12 zumindest einen Vorsprung 13, bevorzugt zwei Vorsprünge 13, auf. Der Vorsprung 13 weist eine Ausnehmung 14 auf, welche ein offenes Ende 15 zur Aufnahme der Printplatte 2 aufweist. Die Höhe der Ausnehmung 14 entspricht im Wesentlichen der Dicke der Printplatte 2, sodass die Ausnehmung 14 die Printplatte 2 im befestigten Zustand aufnehmen kann.

Dadurch kann die Printplatte 2 lösbar in der Ausnehmung 14 fixiert werden, ohne dass zusätzliche Hilfsmittel erforderlich sind.

Ebenso ist der Vorsprung 13 am offenen Ende 15 der Ausnehmung 14 abgeschrägt, wodurch sich eine schräge Fläche 16 ergibt. Diese schräge Fläche 16 erleichtert die Aufnahme bzw. die Positionierung der Printplatte 2 zur lösbaren Befestigung am Gehäuse 1 bzw. am Kühlkörper 5.

Zur Befestigung der Printplatte 2 am Kühlkörper 5, weist dieser eine entsprechende Anzahl, bevorzugt drei, von Führungsschienen 17 auf. Die Führungsschienen 17 sind korrespondierend zur Unterseite 11 des Befestigungselementes 8 ausgebildet. Das heißt, dass die Führungsschienen 17 den Querbalken 10 des Befestigungselementes 8 aufnehmen, wobei der Balken 9 durch die Nut 18 aus der Führungsschiene 17 herausragt.

Somit definiert die Höhe des Balkens 9 den Abstand zwischen Kühlkörper 5 und Printplatte 2. Grundsätzlich entspricht dieser Abstand dem Abstand zwischen der Unterseite 19 der Printplatte 2 und der planflächigen Seite 7 des Kühlelementes 6.

Damit die Printplatte 2 an den Ausnehmungen 14 der Vorsprünge 13 der Befestigungselemente 8 befestigt werden kann, weist die Printplatte 2 entsprechende Ausnehmungen 22 auf. Die Anzahl der Ausnehmungen 22 entspricht der Anzahl der Vorsprünge 13. Das heißt, dass bevorzugt zwei Ausnehmungen 22 entsprechend der zwei Vorsprünge 13 pro Befestigungselement 8 angeordnet sind. Die Form der Ausnehmungen 22 entspricht einem sogenannten Langloch, wodurch die Vorsprünge 13 aufgenommen werden können und entsprechend über die Printplatte 2 ragen. Somit wird ermöglicht, dass die Printplatte 2 in die Ausnehmungen 14 der Vorsprünge 13 geschoben und fixiert werden kann.

Bevorzugt erfolgt nun die Montage der Printplatte 2 am Kühlkörper 5 bzw. am Gehäuse 1 derart, dass die Printplatte 2 aufliegend auf den Befestigungselementen 8 in die Führungsschienen 17 am Kühlkörper 5 geschoben wird.

Hierzu wird bevorzugt der Kühlkörper 5 auf eine der Stirnflächen, welche durch eine Seitenwand 21 schließbar ist, gestellt, sodass beispielsweise die Nut 18 bzw. die Führungsschiene 17 senkrecht steht und eine Stirnfläche durch eine Tischplatte geschlossen ist. Anschließend werden bevorzugt die Vorsprünge 13 der Befestigungselemente 8 in die Ausnehmungen 22 der Printplatte 2 geschoben, sodass die Printplatte 2 von den Vorsprüngen 13 gehalten, jedoch nicht fixiert wird. Dies wird durch die schrägen Flächen 16 der Vorsprünge 13 ermöglicht.

Nun werden die Befestigungselemente 8 und die Printplatte 2 gemeinsam und derart in die Führungsschienen 17 eingeschoben, dass die Ausnehmung 14 bzw. das offene Ende 15 nach oben gerichtet ist. Dadurch wird die Printplatte 2 durch die schräge Fläche 16 der Vorsprünge 13 gehalten, wodurch das Einschieben erleichtert wird. Dadurch, dass die Printplatte 2 an den schrägen Flächen 16 der Vorsprünge 13 gehalten wird, besteht ein minimaler Abstand zwischen Kühlelement 6 und Kühlkörper 5, sodass kein Kontakt während dem Einschieben besteht. Das Einschieben ist zu Ende, sobald die Befestigungselemente 8 am Ende der Führungsschienen 17 angelangt sind, sprich an der Tischplatte anstehen. Somit ist ein entsprechender Widerstand vorhanden, sodass die Printplatte 2 durch eine ruckartige Bewegung in die Ausnehmung 14 der Vorsprünge 13 gedrückt werden kann. Dadurch wird die Printplatte 2 in den Ausnehmungen 14 der Vorsprünge 13 fixiert und gleichzeitig die planflächige Seite 7 des Kühlelementes 6 an den Kühlkörper 5 gepresst und ein Kontakt hergestellt. Somit gewährleisten die Ausnehmungen 14 auch einen erforderlichen Gegendruck, sodass der Kontakt zwischen Kühlelement 6 und Kühlkörper 5 bestehen bleibt.

Der Kontakt bewirkt einerseits, dass die Wärme vom Leistungsteil 4 über das Kühlelement 6 und in weiterer Folge über den Kühlkörper 5 an die Umgebungsluft außerhalb des Kühlkörpers 5 abgegeben wird. Andererseits bewirkt das Kühlelement 6, welches an den Kühlkörper 5 gepresst ist, dass die Printplatte 2 gegen ein Verrutschen in den Führungsschienen 17 gesichert ist. Somit dient das Kühlelement 6 auch als Druckelement, da es den entsprechenden Druck gegen ein Verrutschen herstellt. Ebenso wird durch die ruckartige Bewegung für die Befestigung der Printplatte 2 die Position der Befestigungselemente 8 nicht mehr verändert, wodurch die Montage der Seitenwände 21 des Gehäuses 1 bzw. des Kühlkörpers 5 problemlos ermöglicht wird. Hierbei bewirken die Seitenwände 21 ebenso, dass die Printplatte 2 zusätzlich gegen ein Verrutschen gesichert ist. Dies ist insbesondere dann erforderlich, wenn eine Printplatte 2 ohne erforderliche Wärmeabfuhr, sprich Kühlelement 6, eingesetzt wird.

Selbstverständlich ist es auch möglich, dass zuerst die Befestigungselemente 8 in die Führungsschienen 17 geschoben werden, anschließend die Printplatte 2 auf die Befestigungselemente 8 gelegt wird, sodass die Vorsprünge 13 durch die Ausnehmungen 22 ragen, und die Printplatte 2 durch eine ruckartige Befestigung fixiert wird.

Ebenso ist es auch möglich, dass der Kontakt zwischen Kühlelement 6 und Kühlkörper 5 auf eine andere Art und Weise hergestellt wird, beispielsweise durch eine eigene Führungsschiene im Kühlkörper 5.

Des weiteren besteht auch die Möglichkeit, dass das Kühlelement 6 nicht an der Unterseite 19 der Printplatte 2 montiert ist, sondern an der entsprechenden Position auf der Unterseite 25 des Gehäuses zwischen den Führungsschienen 17. Hierbei ist selbstverständlich zu beachten, dass die Printplatte 2 von der richtigen Seite in das Gehäuse 2 geschoben wird, sodass die vom Leistungsteil 4 produzierte Wärme wiederum über das Kühlelement 6 und über den Kühlkörper 5 an die Umgebungsluft abgeleitet werden kann.

Auch ist es möglich, dass die Führungsschiene 17 im Gehäuse nicht durchgängig ausgebildet ist, sondern auf einer Seite endet, sodass ein entsprechender Gegenhalt bzw. Anstoßfläche für das Befestigungselement 8 beim Einschieben geschaffen wird.

Durch eine derartige Befestigung ist die Printplatte 2 fest mit dem Gehäuse 1 bzw. dem Kühlkörper 5 verbunden. Damit die Printplatte 2 jedoch zusätzlich zum Verrutschen auch vor Vibrationen geschützt ist, ist das Kühlelement 6 nicht direkt an der Printplatte 2 befestigt, sondern über ein wärmeleitfähiges Element 20. Somit wird die vom Leistungsteil 4 produzierte Wärme über das wärmeleitfähige Element 20, welches beispielsweise aus Silicon Polymer besteht, das Kühlelement 6 und dem Kühlkörper 5 an die Umgebungsluft außerhalb des Gehäuses 1 abgegeben. Ebenso hat das wärmeleitfähige Element 20 die Eigenschaft, die Printplatte 2 in Befestigtem Zustand, das heißt, dass das Kühlelement 6 an den Kühlkörper 5 gepresst ist bzw. die Printplatte 2 in der Ausnehmung 14 fixiert ist, vor Vibrationen des Gehäuses 1 bzw. des Kühlkörpers 5 zu schützen. Dadurch kann das Gehäuse 1 für Anwendungen eingesetzt werden, welche häufig oder ständig Vibrationen ausgesetzt sind, wie beispielsweise in einem Kraftfahrzeug. Des weiteren wird durch das wärmeleitfähige Element 20 verhindert, dass die Schaltung bzw. die Bauteile 3 auf der Printplatte 2 von den Vibrationen negativ beeinflusst wird.

Nachdem die Printplatte 2 am Kühlkörper 5 befestigt wurde, können die Stirnflächen des Gehäuses 1 mit den Seitenwänden 21 geschlossen werden, sodass ein Schutz vor jeglichen Witterungseinflüssen gegeben ist. Selbstverständlich können die Seitenwände 21 auch dementsprechend witterungsbeständige Öffnungen aufweisen, damit beispielsweise die Printplatte 2 bzw. die Schaltung mit Strom versorgt oder eine Batterie zum Laden angeschlossen werden kann.

Muss beispielsweise für Reparaturzwecke die Printplatte 2 vom Gehäuse 1 bzw. dem Kühlkörper 5 gelöst werden, erfolgt dies in umgekehrter Reihenfolge wie bei der Befestigung. Das heißt, dass die Printplatte 2 durch eine ruckartige Bewegung von der Fixierung in den Ausnehmungen 14 der Vorsprünge 13 gelöst wird. Dadurch wird ebenso das Kühlelement 6 vom Kühlkörper 5 gelöst und die Printplatte 2 kann zusammen mit den Befestigungselementen 8 aus dem Gehäuse 1 geschoben und entfernt werden.

Selbstverständlich ist es auch möglich, dass die Befestigungselemente 8 in den Führungsschienen 17 verbleiben, und nur die Printplatte 2 entfernt wird.

Wesentlich ist hierbei, dass zwischen dem Gehäuse 1 und dem Kühlelement 6 ein entsprechender Druck aufgebaut wird, sodass ein fester Sitz der Printplatte 2 im Gehäuse 1 gegeben ist. Hierbei ist es auch möglich, ein derartiges System bei Printplatten 2 einzusetzen, welche keine Wärmeabfuhr benötigen. Dabei wird lediglich das Kühlelement 6 durch ein Druckelement ersetzt, d.h., dass ein entsprechendes Druckelement an der Printplatte 2 oder an dem Gehäuse 1 befestigt wird, sodass anschließend beim Einschieben der Printplatte 2 mit den daran befestigten Befestigungselementen 8 ein Druck aufgebaut wird. Die Montage bzw. Demontage entspricht dabei entsprechend der zuvor beschriebenen Ausführungsform mit dem Kühlelement 6, sodass diese nicht mehr wiederholt wird. Hierzu kann das Druckelement unterschiedlich ausgebildet werden. Beispielsweise aus Gummi oder einem festen Kunststoff, der entsprechend beweglich an der Printplatte 2 oder dem Gehäuse 1 befestigt ist.

## Patentansprüche

1. Montagevorrichtung für eine Printplatte (2) in einem Gehäuse (1), wobei das Gehäuse (1) zumindest eine lösbare stirnseitige Abdeckung bzw. Seitenwand (21) und zumindest eine in der Innenseite (26) integrierte Führungsschiene (17) zur Fixierung der Printplatte (2) aufweist, wobei das Gehäuse (1) als Kühlkörper (5) ausgebildet ist, zur Fixierung der Printplatte (2) zumindest ein Befestigungselement (8) und ein Druckelement (6) vorgesehen sind, die Printplatte (2) über das an der Printplatte (2) oder dem Gehäuse (1) befestigte Druckelement fixiert ist, wobei durch eine ruckartige Bewegung die Printplatte (2) an eine Innenseite (26) des Gehäuses (1) pressbar ist, **dadurch gekennzeichnet, dass** das Druckelement (6) als Kühlelement (6) ausgebildet ist und zur Wärmeübertragung von der Printplatte (2) zum Gehäuse (1) dient, wobei das Befestigungselement (8) in die Führungsschiene (17) einführbar ist und gleichzeitig zur Aufnahme der Printplatte (2) ausgebildet ist.

2. Montagevorrichtung nach Anspruch 1, **dadurch gekennzeichnet, dass** das Befestigungselement (8) auf einer Seite korrespondierend zur Führungsschiene (17) ausgebildet ist und auf der gegenüberliegenden Seite zur lösbaren Befestigung der Printplatte (2) zumindest einen Vorsprung (13) aufweist.

3. Montagevorrichtung nach Anspruch 2, **dadurch gekennzeichnet, dass** durch den Vorsprung (13) ein erforderlicher Gegendruck zur Fixierung der Printplatte (2) gewährleistet ist.

4. Montagevorrichtung nach Anspruch 2 oder 3, **dadurch gekennzeichnet, dass** im Vorsprung (13) eine Ausnehmung (14) mit einem offenem Ende (15) zur Aufnahme der Printplatte (2) angeordnet ist und dass an einem Ende der Ausnehmung (14) der Vorsprung (13) mit dem Befestigungselement (8) verbunden ist.

5. Montagevorrichtung nach Anspruch 4, **dadurch gekennzeichnet, dass** am offenen Ende (15) der Ausnehmung (14) des Vorsprungs (13) eine schräge Fläche (16) angeordnet ist.

6. Montagevorrichtung nach Anspruch 5, **dadurch gekennzeichnet, dass** die schräge Fläche (16) die Printplatte (2) beim Einschieben in die Führungsschienen (17) hält.

7. Montagevorrichtung nach einem der Ansprüche 4 bis 6, **dadurch gekennzeichnet, dass** die Höhe der Ausnehmung (14) im wesentlichen der Dicke der Printplatte (2) entspricht.

8. Montagevorrichtung nach einem der Ansprüche 1 bis 7, **dadurch gekennzeichnet, dass** das Befestigungselement (8) im wesentlichen die Form einer Schiene aufweist.

9. Montagevorrichtung nach einem der Ansprüche 1 bis 8, **dadurch gekennzeichnet, dass** die Printplatte (2) zumindest eine Ausnehmung (22) für die Befestigung über das Befestigungselement (8) aufweist.

10. Montagevorrichtung nach Anspruch 9, **dadurch gekennzeichnet, dass** die Ausnehmung (22) an der Printplatte (2) zur Aufnahme des Vorsprunges (13) ausgebildet ist.

11. Montagevorrichtung nach einem der Ansprüche 1 bis 10, **dadurch gekennzeichnet, dass** durch das Befestigungselement (8) der Abstand zwischen Kühlkörper (5) und Printplatte (2) definiert und dieser variabel ist.

12. Montagevorrichtung nach einem der Ansprüche 1 bis 11, **dadurch gekennzeichnet, dass** das Einschieben des Befestigungselementes (8) und der Printplatte (2) in das Gehäuse (1) über eine Stirnseite des Gehäuses (1) erfolgt.

13. Montagevorrichtung nach einem der Ansprüche 1 bis 12, **dadurch gekennzeichnet, dass** das Einschieben des Befestigungselementes (8) und der Printplatte (2) in das Gehäuse (1) gemeinsam erfolgt.

14. Montagevorrichtung nach einem der Ansprüche 1 bis 13, **dadurch gekennzeichnet, dass** das Kühlelement (6) nach der Befestigung der Printplatte (2) im Gehäuse (1) einen planflächigen Kontakt zum Gehäuse (1) herstellt.

15. Montagevorrichtung nach einem der Ansprüche 1 bis 14, **dadurch gekennzeichnet, dass** die Befestigung der Printplatte (2) im Gehäuse (1) ohne Hilfsmittel durchführbar ist.

## Claims

1. A mounting device for a printed board (2) provided in a casing (1), said casing (1) including at least one detachable end-side cover or lateral wall (21) and at least one guide rail (17) integrated in the inner side (26) for fastening the printed board (2), wherein the casing (1) is designed as a cooling body (5), at least one fastening element (8) and a pressure element (6) are provided for fastening the printed board (2), the printed board (2) is fastened via the pressure element secured to the printed board (2) or the casing (1), said printed board (2) being pressable at an inner side (26) of the casing (1) by a jerky movement, **characterized in that** the pressure element (6) is designed as a cooling element (6) and serves to transmit heat from the printed board (2) to the casing (1), wherein the fastening element (8) is capable of being inserted into the guide rail (17) and, at the same time, configured to receive the printed board (2).

2. A mounting device according to claim 1, **characterized in that** the fastening element (8), on one side, is designed to correspond to the guide rail (17) and, on the opposite side, comprises at least one projection (13) for the detachable fastening of the printed board (2).

3. A mounting device according to claim 2, **characterized in that** the projection (13) provides the counter-pressure required for the fastening of the printed board (2).

4. A mounting device according to claim 2 or 3, **characterized in that** a recess (14) having an open end (15) for receiving the printed board (2) is provided in the projection (13), and that the projection (13) is connected with the fastening element (8) on one end of the recess (14).

5. A mounting device according to claim 4, **characterized in that** an oblique surface (16) is provided on the open end (15) of the recess (14) of the projection (13).

6. A mounting device according to claim 5, **characterized in that** the oblique surface (16) retains the printed board (2) during its insertion into the guide rail (17).

7. A mounting device according to any one of claims 4 to 6, **characterized in that** the height of the recess (14) substantially corresponds to the thickness of the printed board (2).

8. A mounting device according to any one of claims 1 to 7, **characterized in that** the fastening element (8) is substantially rail-shaped.

9. A mounting device according to any one of claims 1 to 8, **characterized in that** the printed board (2) comprises at least one recess (22) for its fastening via the fastening element (8).

10. A mounting device according to claim 9, **characterized in that** the recess (22) on the printed board (2) is configured to receive the projection (13).

11. A mounting device according to any one of claims 1 to 10, **characterized in that** the distance between the cooling body (5) and the printed board (2) is defined by the fastening element (8) and is variable.

12. A mounting device according to any one of claims 1 to 11, **characterized in that** the insertion of the fastening element (8) and of the printed board (2) into the casing (1) are effected via an end side of the casing (1).

13. A mounting device according to any one of claims 1 to 12, **characterized in that** the insertion of the fastening element (8) and of the printed board (2) into the casing (1) are effected collectively.

14. A mounting device according to any one of claims 1 to 13 **characterized in that** the cooling element (6) provides a planar contact with the casing (1) after the fastening of the printed board (2) in the casing (1).

15. A mounting device according to any one of claims 1 to 14, **characterized in that** the fastening of the printed board (2) in the casing (1) is feasible without auxiliary means.

## Revendications

1. Dispositif de montage pour une plaque de circuits imprimés (2) dans un boîtier (1), dans lequel le boîtier (1) présente au moins un couvercle amovible côté frontal ou une paroi latérale (21) amovible et au moins un rail de guidage (17) intégré au côté interne (26) pour fixer la plaque de circuits imprimés (2), dans lequel le boîtier (1) se présente sous la forme d'un dissipateur de chaleur (5), au moins un élément de fixation (8) et un élément presseur (6) étant prévus pour fixer la plaque de circuits imprimés (2), la plaque de circuits imprimés (2) est fixée par le biais de l'élément presseur fixé à la plaque de circuits imprimés (2) ou au boîtier (1), la plaque de circuits imprimés (2) pouvant être pressée contre un côté interne (26) du boîtier (1) par un mouvement par à-coups, **caractérisé en ce que** l'élément presseur (6) se présente sous la forme d'un élément de refroidissement (6) et sert au transfert de chaleur de la plaque de circuits imprimés (2) au boîtier (1), l'élément de fixation (8) étant insérable dans le rail de guidage (17) et étant simultanément conformé pour recevoir la plaque de circuits imprimés (2).

2. Dispositif de montage selon la revendication 1, **caractérisé en ce que** l'élément de fixation (8) est formé sur un côté de manière correspondante au rail de guidage (17) et présente sur le côté opposé au moins une saillie (13) pour la fixation amovible de la plaque de circuits imprimés (2).

3. Dispositif de montage selon la revendication 2, **caractérisé en ce que** la saillie (13) assure une contre-pression nécessaire pour fixer la plaque de circuits imprimés (2).

4. Dispositif de montage selon la revendication 2 ou 3, **caractérisé en ce qu'**un évidement (14) avec une extrémité ouverte (15) pour recevoir la plaque de circuits imprimés (2) est aménagé dans la saillie (13) et **en ce qu'**à une extrémité de l'évidement (14), la saillie (13) est raccordée à l'élément de fixation (8).

5. Dispositif de montage selon la revendication 4, **caractérisé en ce qu'**une surface oblique (16) est aménagée à l'extrémité ouverte (15) de l'évidement (14) de la saillie (13).

6. Dispositif de montage selon la revendication 5, **caractérisé en ce que** la surface oblique (16) maintient la plaque de circuits imprimés (2) lors de l'insertion dans les rails de guidage (17).

7. Dispositif de montage selon l'une quelconque des revendications 4 à 6, **caractérisé en ce que** la hauteur de l'évidement (14) correspond sensiblement à l'épaisseur de la plaque de circuits imprimés (2).

8. Dispositif de montage selon l'une quelconque des revendications 1 à 7, **caractérisé en ce que** l'élément de fixation (8) présente sensiblement la forme d'un rail.

9. Dispositif de montage selon l'une quelconque des revendications 1 à 8, **caractérisé en ce que** la plaque de circuits imprimés (2) présente au moins un évidement (22) pour la fixation par l'élément de fixation (8).

10. Dispositif de montage selon la revendication 9, **caractérisé en ce que** l'évidement (22) est ménagé sur la plaque de circuits imprimés (2) pour recevoir la saillie (13).

11. Dispositif de montage selon l'une quelconque des revendications 1 à 10, **caractérisé en ce que** l'écart entre le dissipateur de chaleur (5) et la plaque de circuits imprimés (2) est défini par l'élément de fixation et est variable.

12. Dispositif de montage selon l'une quelconque des revendications 1 à 11, **caractérisé en ce que** l'insertion de l'élément de fixation (8) et de la plaque de circuits imprimés (2) dans le boîtier (1) s'effectue par un côté frontal du boîtier (1).

13. Dispositif de montage selon l'une quelconque des revendications 1 à 12, **caractérisé en ce que** l'insertion de l'élément de fixation (8) et de la plaque de circuits imprimés (2) dans le boîtier (1) se fait conjointement.

14. Dispositif de montage selon l'une quelconque des revendications 1 à 13, **caractérisé en ce qu'**après la fixation de la plaque de circuits imprimés (2) dans le boîtier (1), l'élément de refroidissement (6) établit un contact plan avec le boîtier (1).

15. Dispositif de montage selon l'une quelconque des revendications 1 à 14, **caractérisé en ce que** la fixation de la plaque de circuits imprimés (2) dans le boîtier (1) est réalisable sans moyens auxiliaires.
